# EUROPEAN PATENT APPLICATION

(11) **EP 4 181 175 A1**
(43) Date of publication of application: **17.05.2023**
(21) Application number: 21837331.4
(22) Date of filing: 06.07.2021
(51) Int. Cl.: H01L 21/304

(54) **SUBSTRATE PROCESSING MODULE AND SUBSTRATE PROCESSING APPARATUS**

(30) Priority: 09.07.2020 WO PCT/JP2020/026914
(71) Applicant: Toho Kasei Co., Ltd., Yamatokoriyama-shi, Nara 639-1031 (JP)
(72) Inventor: DEGUCHI, Yasunori, Yamatokoriyama-shi, Nara 639-1031 (JP)
(74) Representative: Eisenführ Speiser
(86) International application number: PCT/JP2021/025473
(87) International publication number: WO 2022/009885

(57) **Abstract**

A substrate processing module (7) includes a first tank (34) and a second tank (32) that are arranged in a first direction and in which a substrate (4) can be arranged, a first conveyor (11) that moves the substrate (4) in the first direction, and a second conveyor (48) that moves the substrate (4) in a second direction intersecting the first direction; and a vertical conveyor (13) that is connected to the first conveyor (11) and vertically moves the substrate (4), wherein a first actuator (12) of the first conveyor (11) and a second actuator (41) of the second conveyor (48) are respectively arranged in drive spaces (B1, B2) separated from a processing space (A) accessible to the first tank (34) and the second tank (32).

## Description

### TECHNICAL FIELD

The present invention relates to a substrate processing module and a substrate processing apparatus for processing a substrate.

### BACKGROUND ART

As a substrate processing apparatus, there is a cleaning apparatus that processes various substrates (hereinafter, referred to "substrate") such as a semiconductor wafer with predetermined liquid chemical, and then cleans the substrate with cleaning liquid such as pure water to remove a foreign matter adhering to a surface of the substrate. As the cleaning apparatus, there is a wettype cleaning apparatus that performs cleaning processing by immersing the substrate in liquid chemical and cleaning liquid.

Patent Document 1 discloses a substrate processing apparatus in which a plurality of pairs of a liquid chemical tank and a cleaning tank are arranged in a longitudinal direction of the apparatus, and a main conveyance mechanism and a sub-conveyance mechanism are included. The main conveyance mechanism moves a plurality of the substrates in the longitudinal direction from one end side to the other end side of the apparatus. The sub-conveyance mechanism moves a plurality of the substrates in the longitudinal direction and a vertical direction within a range of a pair of the liquid chemical tank and the cleaning tank.

### PRIOR ART DOCUMENT

### PATENT DOCUMENT

Patent Document 1: JP 2018-56158 A

### SUMMARY OF THE INVENTION

### PROBLEMS TO BE SOLVED BY THE INVENTION

In Patent Document 1, since a plurality of pairs of the liquid chemical tank and the cleaning tank are adjacent to each other in the longitudinal direction of the apparatus, due to an atmosphere of certain liquid chemical stored in a certain liquid chemical tank, contamination of another liquid chemical tank and a cleaning tank located adjacently occurs (that is, contamination by liquid chemical). Further, since the main conveyance mechanism and the sub-conveyance mechanism face the liquid chemical tank and the cleaning tank, contamination due to particles occurs. Further, since a plurality of pairs of the liquid chemical tank and the cleaning tank are arranged in the longitudinal direction, the apparatus is long in the longitudinal direction. Further, since a plurality of pairs of the liquid chemical tank and the cleaning tank are fixed and installed in the apparatus, it is not possible to flexibly respond to the need to change a processing process.

Therefore, it is desirable to suppress contamination due to liquid chemical, particles, or the like, reduce size of the apparatus, and enable a highly expandable configuration with flexible response.

In view of the above, an object of the present invention is to provide a substrate processing module and a substrate processing apparatus that require a smaller installation area and are capable of suppressing contamination.

### MEANS FOR SOLVING THE PROBLEMS

In order to solve the above problem, a substrate processing module according to an aspect of the present invention includes a first tank and a second tank that are arranged in a first direction and in which a substrate can be placed, a first conveyor that moves the substrate in the first direction, a second conveyor that moves the substrate in a second direction intersecting the first direction, and a vertical conveyor that is connected to the first conveyor and vertically moves the substrate, wherein a first actuator of the first conveyor and a second actuator of the second conveyor are respectively arranged in drive spaces separated from a processing space accessible to the first tank and the second tank.

Further, a substrate processing apparatus according to an aspect of the present invention includes the substrate processing module and another module connected to the substrate processing module in the second direction.

### EFFECTS OF THE INVENTION

According to the present invention, it is possible to reduce an installation area and suppress contamination.

### BRIEF DESCRIPTION OF THE DRAWINGS

FIG. 1 is a perspective view for explaining a substrate processing apparatus according to an embodiment.
FIG. 2 is a perspective view for explaining a constituent of the substrate processing apparatus illustrated in FIG. 1.
FIG. 3 is a perspective view for explaining a chemical module in the substrate processing apparatus illustrated in FIG. 1.
FIG. 4 is a perspective view explaining a second conveyance mechanism in the substrate processing apparatus illustrated in FIG. 1.
FIG. 5 is a perspective view for explaining a main part of the chemical module illustrated in FIG. 3.
FIG. 6 is a perspective view for explaining an unloading module in the substrate processing apparatus illustrated in FIG. 1.
FIG. 7 is a perspective view illustrating a loading module in the substrate processing apparatus illustrated in FIG. 1.
FIG. 8 is a diagram for explaining movement of a vertical conveyor in the chemical module illustrated in FIG. 3.
FIG. 9 is a diagram for explaining movement of a first conveyor in the chemical module illustrated in FIG. 3.
FIG. 10 is a diagram for explaining a carrier that holds a substrate.
FIG. 11 is a perspective view explaining a drying module in the substrate processing apparatus illustrated in FIG. 1.
FIG. 12 is a schematic diagram of the second conveyance mechanism in plan view.
FIG. 13 is a schematic perspective view illustrating the chemical module.
FIG. 14 is a diagram for explaining movement of the first conveyor in the chemical module.
FIG. 15 is a schematic plan view illustrating a processing space according to a variation.
FIG. 16A is a schematic diagram for explaining an example of operation of the substrate processing apparatus.
FIG. 16B is a schematic diagram for explaining an example of operation of the substrate processing apparatus.
FIG. 16C is a schematic diagram for explaining an example of operation of the substrate processing apparatus.
FIG. 16D is a schematic diagram for explaining an example of operation of the substrate processing apparatus.
FIG. 16E is a schematic diagram for explaining an example of operation of the substrate processing apparatus.
FIG. 16F is a schematic diagram for explaining an example of operation of the substrate processing apparatus.
FIG. 16G is a schematic diagram for explaining an example of operation of the substrate processing apparatus.
FIG. 16H is a schematic diagram for explaining an example of operation of the substrate processing apparatus.
FIG. 16I is a schematic diagram for explaining an example of operation of the substrate processing apparatus.
FIG. 16J is a schematic diagram for explaining an example of operation of the substrate processing apparatus.
FIG. 16K is a schematic diagram for explaining an example of operation of the substrate processing apparatus.
FIG. 16L is a schematic diagram for explaining an example of operation of the substrate processing apparatus.
FIG. 17 is a schematic plan view illustrating an operation example in a case where a substrate is processed in one batch.
FIG. 18 is a schematic plan view illustrating an operation example in a case where a substrate is processed in a plurality of batches.
FIG. 19 is a schematic plan view illustrating a variation of a first tank and a second tank.

### MODE FOR CARRYING OUT THE INVENTION

Hereinafter, an embodiment of a substrate processing apparatus 1 according to the present invention will be described with reference to the drawings.

Note that, in the present description, "module" means a constituent that is standardized and configured to be detachable (replaceable), and is handled as one collective constituent unit when used. Further, "first direction" means a direction in which a pair of a liquid chemical tank and a cleaning tank are arranged, that is, a lateral direction (for example, a front-rear direction or a vertical direction) of the substrate processing apparatus 1. Further, "second direction" is a direction crossing the first direction and the vertical direction, and means a direction in which a plurality of modules are continuously provided, that is, a longitudinal direction (for example, a left-right direction or a horizontal direction) of the substrate processing apparatus 1. The first direction may be referred to as a transverse direction (TD) direction, and the second direction may be referred to as a machine direction (MD) direction. In the drawings, the "first direction" is illustrated as a Y-axis direction, the "second direction" is illustrated as an X-axis direction, and the "vertical direction" is illustrated as a Z-axis direction. The first direction, the second direction, and the vertical direction cross each other (for example, are orthogonal to each other) .

### [Embodiment]

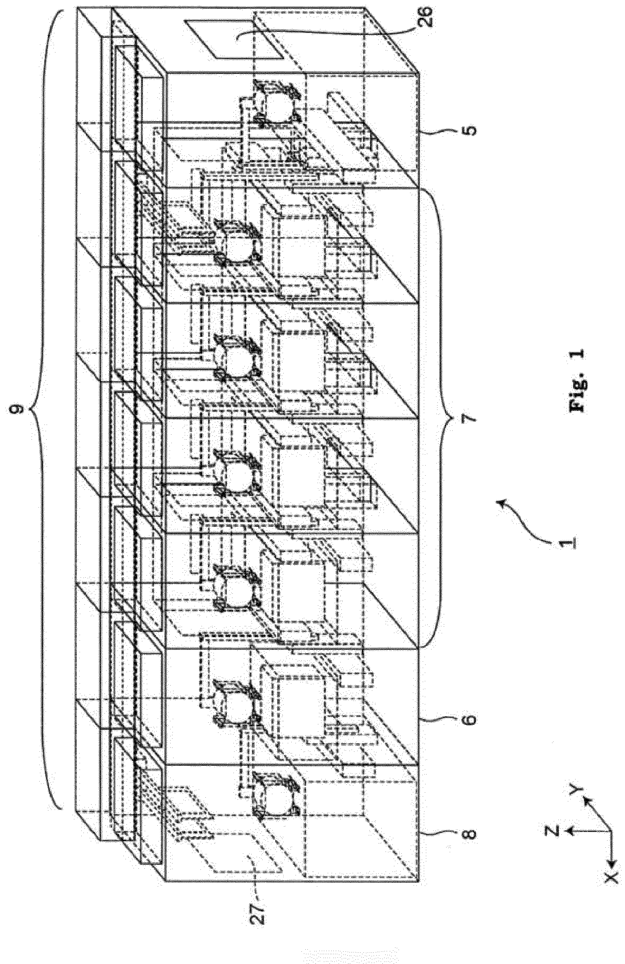

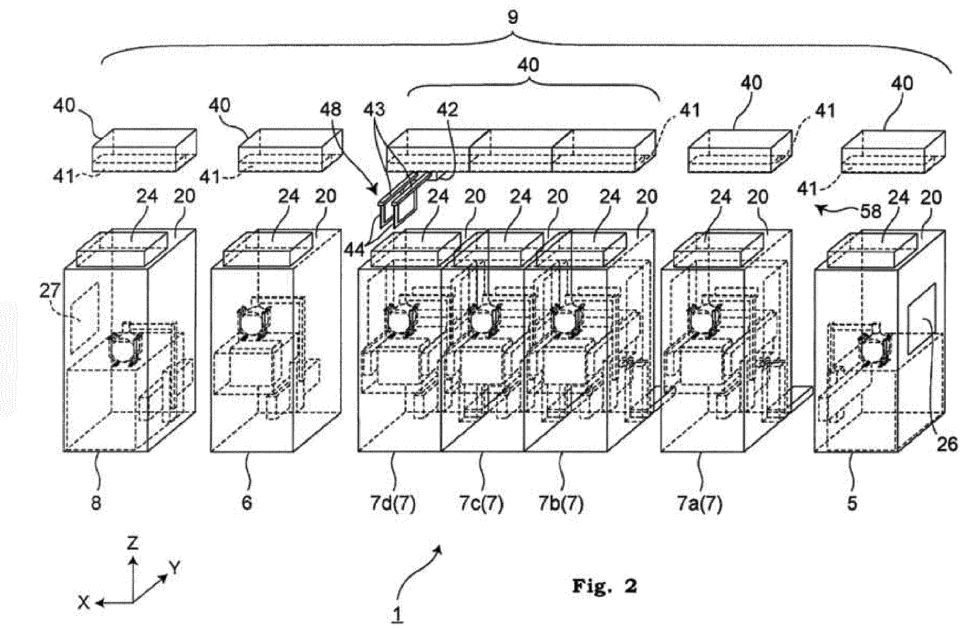

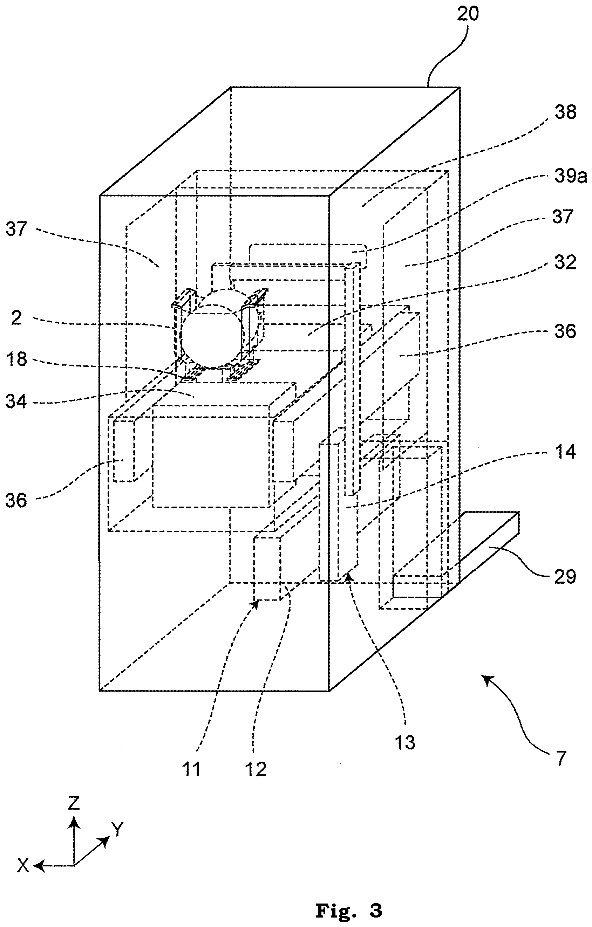

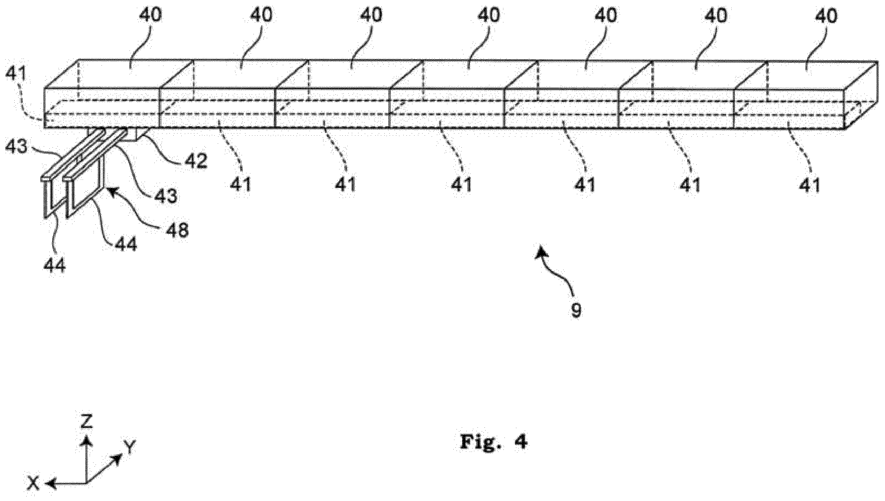

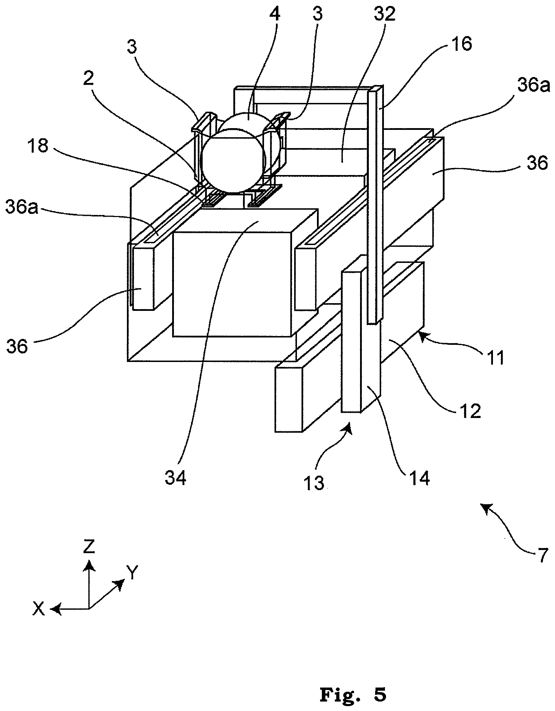

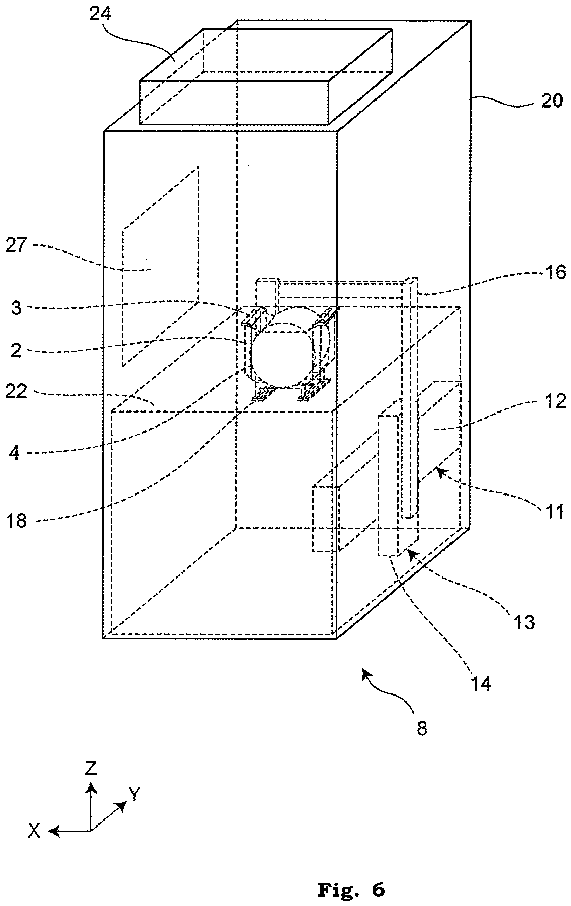

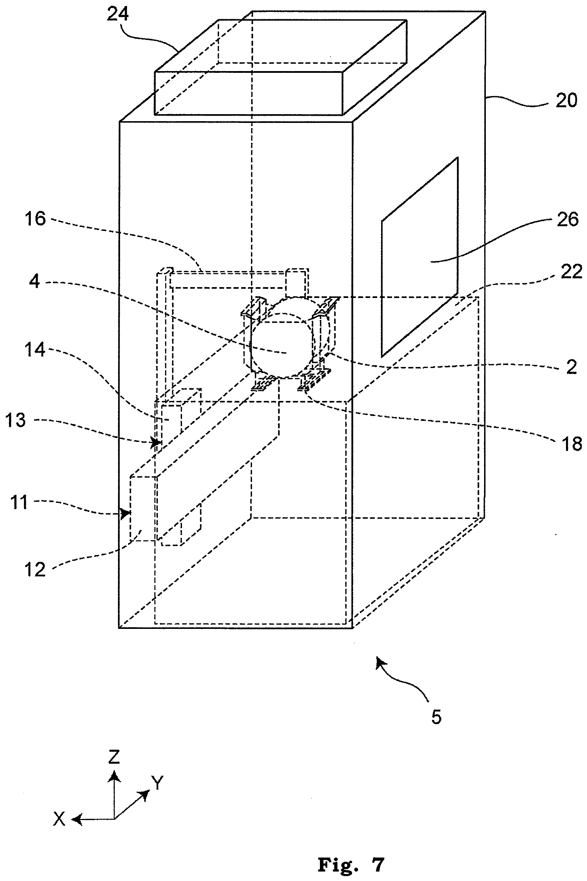

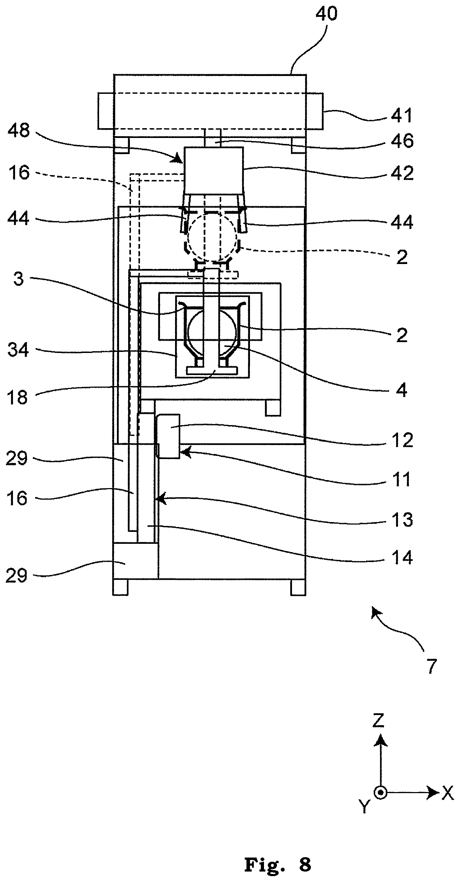

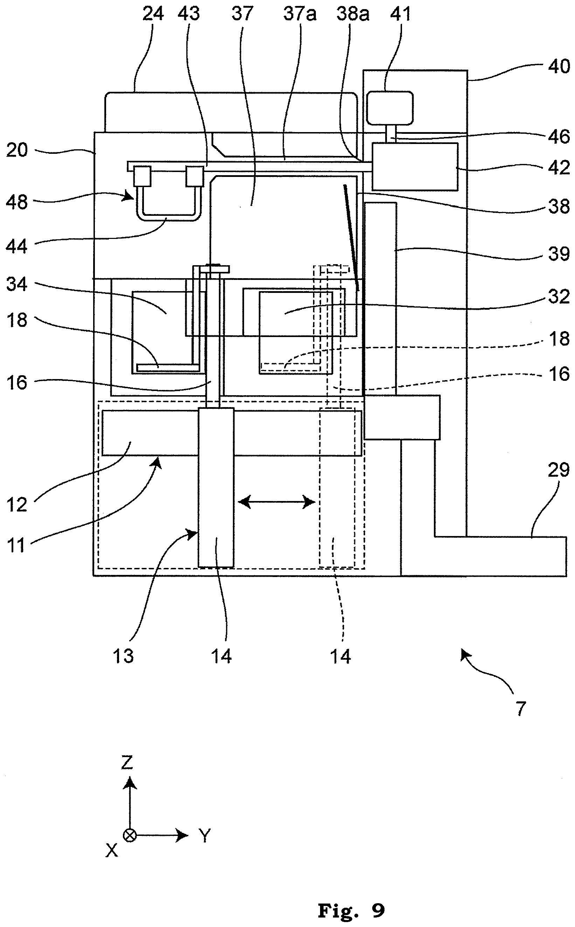

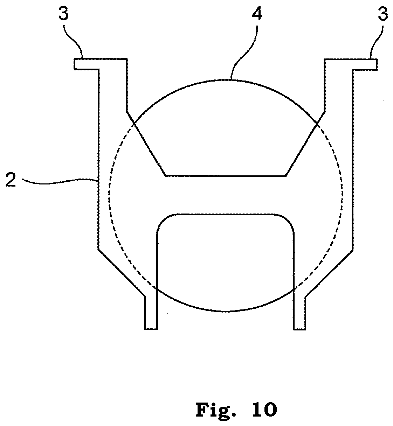

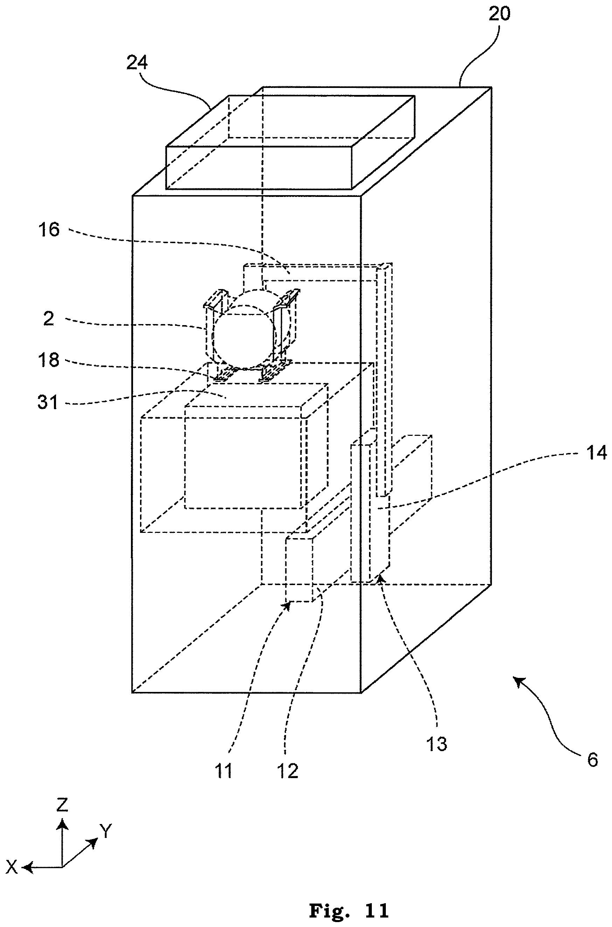

The substrate processing apparatus 1 according to an embodiment will be described with reference to FIGS. 1 to 10. FIG. 1 is a perspective view illustrating the substrate processing apparatus 1 according to an embodiment. FIG. 2 is a perspective view for explaining a constituent of the substrate processing apparatus 1 illustrated in FIG. 1. FIG. 3 is a perspective view for explaining a chemical module 7 in the substrate processing apparatus 1 illustrated in FIG. 1. FIG. 4 is a perspective view explaining a second conveyance mechanism 9 in the substrate processing apparatus 1 illustrated in FIG. 1. FIG. 5 is a perspective view for explaining a main part of the chemical module 7 illustrated in FIG. 3. FIG. 6 is a perspective view for explaining an unloading module 8 in the substrate processing apparatus 1 illustrated in FIG. 1. FIG. 7 is a perspective view illustrating a loading module 5 in the substrate processing apparatus 1 illustrated in FIG. 1. FIG. 8 is a diagram for explaining movement of a vertical conveyor 13 in the chemical module 7 illustrated in FIG. 3. FIG. 9 is a diagram for explaining movement of a first conveyor 11 in the chemical module 7 illustrated in FIG. 3. FIG. 10 is a diagram for explaining a carrier 2 that holds a substrate 4. FIG. 11 is a perspective view explaining a drying module 6 in the substrate processing apparatus 1 illustrated in FIG. 1.

The substrate processing apparatus 1 includes at least one module for applying various types of processing on a plurality of the substrates 4 held by the carrier 2. Specific examples of the substrate 4 include a semiconductor substrate, a glass substrate for a liquid crystal display apparatus, a glass substrate for a photomask, a substrate for an optical disk, a MEMS sensor substrate, and a solar cell panel. The module has a standardized casing 20, and is configured to be detachable (replaceable) in the second direction (the X-axis direction or the longitudinal direction of the substrate processing apparatus 1, and is hereinafter referred to as "second direction"). A fan filter unit 24 is arranged in an upper part of the module. The fan filter unit 24 includes a fan and a filter for taking in air in a clean room and sending the air into the module. The fan filter unit 24 creates downflow of clean air in a processing space in the module. Instead of arranging the fan filter unit 24, another configuration for taking in clean air in a clean room can be used.

As illustrated in FIGS. 1 and 2, the substrate processing apparatus 1 includes, for example, the loading module 5, the drying module 6, the chemical module 7 (substrate processing module), the unloading module 8, and the second conveyance mechanism 9. The loading module 5, the chemical module 7, the drying module 6, and the unloading module 8 are arranged adjacent to each other along the second direction. The loading module 5, the chemical module 7, the drying module 6, and the unloading module 8 are configured to be detachably connected in the second direction. By the above, it is possible to flexibly respond to the need for changing a processing process, and expandability is enhanced.

The second conveyance mechanism 9 extends in the second direction and conveys the carrier 2 holding a plurality of the substrates 4 illustrated in FIG. 10 in the second direction. The second conveyance mechanism 9 is arranged in an upper part of the loading module 5, the chemical module 7, the drying module 6, and the unloading module 8 on the rear side in the first direction (Y axis direction or the lateral direction of the substrate processing apparatus 1, and hereinafter referred to as the "first direction").

The substrate processing apparatus 1 includes a control unit (not illustrated). The control unit performs, for example, operation control and data calculation of each element of the substrate processing apparatus 1. The control unit includes, for example, a central processing unit (CPU), a random access memory (RAM), and a read only memory (ROM). The CPU executes control (for example, control of conveyance operation and the like of the carrier 2 by the first conveyor 11, the vertical conveyor 13, and a second conveyor 48) according to a program stored in the ROM.

In the loading module 5, the substrate 4 before processing is loaded into the apparatus with the carrier 2 as one unit. In the drying module 6, for example, vapor drying of the substrate 4 with isopropyl alcohol (IPA) or the like is executed with the carrier 2 as one unit. In the chemical module 7, cleaning processing of the substrate 4 is executed with the carrier 2 as one unit. In the unloading module 8, the substrate 4 after cleaning processing is unloaded to the outside of the apparatus with the carrier 2 as one unit.

The loading module 5 is also referred to as a loader unit, and is arranged on the upstream side in the second direction of the substrate processing apparatus 1. As illustrated in FIG. 7, the loading module 5 includes a loading unit 26 configured to be openable and closable on a side surface on the upstream side in the second direction of the casing 20. The carrier 2 is loaded into the loading module 5 via the loading unit 26. The carrier 2 loaded into the loading module 5 is placed on the placing table 22. In the inside of the loading module 5, conveyance of the carrier 2 in the first direction is performed by the first conveyor 11 via an arm 16, and conveyance of the carrier 2 in the vertical direction is performed by the vertical conveyor 13 via the arm 16. A first actuator 12 of the first conveyor 11 is arranged below on a side of a placement surface of the placing table 22. A vertical actuator 14 of the vertical conveyor 13 is also arranged below on a side of the placement surface of the placing table 22. That is, by downflow from the fan filter unit 24 and an arm length of the arm 16, the carrier 2 placed on the placing table 22 is isolated so as not to be affected by the first actuator 12 and the vertical actuator 14. By the above, it is possible to suppress contamination of the carrier 2 in the loading module 5 due to particles generated from the first actuator 12 and the vertical actuator 14.

The unloading module 8 is also referred to as an unloader unit, and is arranged on the downstream side in the second direction of the substrate processing apparatus 1. As illustrated in FIG. 6, the carrier 2 loaded into the unloading module 8 is placed on the placing table 22. In the inside of the unloading module 8, conveyance of the carrier 2 in the first direction is performed by the first conveyor 11 via the arm 16, and conveyance of the carrier 2 in the vertical direction is performed by the vertical conveyor 13 via the arm 16. A first actuator 12 of the first conveyor 11 is arranged below on a side of a placement surface of the placing table 22. A vertical actuator 14 of the vertical conveyor 13 is also arranged below on a side of the placement surface of the placing table 22. That is, by downflow from the fan filter unit 24 and an arm length of the arm 16, the carrier 2 placed on the placing table 22 is isolated so as not to be affected by the first actuator 12 and the vertical actuator 14. By the above, it is possible to suppress contamination of the carrier 2 in the unloading module 8 due to particles generated from the first actuator 12 and the vertical actuator 14. The unloading module 8 includes an unloading unit 27 configured to be openable and closable on a side surface on the downstream side in the second direction of the casing 20. The carrier 2 is unloaded to the outside of the unloading module 8, that is, to the outside of the substrate processing apparatus 1 via the unloading unit 27.

Note that, in the above mode, the carrier 2 is conveyed in one direction along the second direction from the loading module 5 toward the unloading module 8, but another mode may be employed. For example, the substrate processing apparatus 1 may include only one of the loading module 5 and the unloading module 8, and the loading module 5 may have functions of both a loader and an unloader, or the unloading module 8 may have functions of both a loader and an unloader. At this time, the carrier 2 is conveyed in both of one direction and the other direction along the second direction (that is, the carrier 2 is reciprocated along the second direction).

The substrate processing apparatus 1 includes at least one of the drying module 6. As illustrated in FIG. 1, the drying module 6 is installed, for example, between the chemical module 7 and the unloading module 8.

As illustrated in FIG. 11, the drying module 6 includes, for example, the first conveyor 11 that conveys the carrier 2 in the first direction and the vertical conveyor 13 that conveys the carrier 2 in the vertical direction, similarly to the other modules 5, 7, and 8. The first conveyor 11 includes the first actuator 12, and the vertical conveyor 13 includes the vertical actuator 14.

The drying module 6 includes a drying chamber 31. The drying chamber 31 is arranged, for example, on the front side in the first direction in the drying module 6. Drying processing for drying the substrate 4 after various types of liquid chemical processing such as various types of liquid chemical cleaning, etching, and resist peeling are performed by the chemical module 7 is performed in the drying chamber 31. In the drying module 6, the carrier 2 holding the substrate 4 is conveyed in the vertical direction with respect to the drying chamber 31 by the vertical conveyor 13 via the arm 16. The first actuator 12 and the vertical actuator 14 are arranged apart from the drying chamber 31 below on a side of the drying chamber 31. Therefore, the drying chamber 31 is isolated so as not to be affected by the first actuator 12 and the vertical actuator 14.

In this drying processing, a publicly-known drying method can be normally used. Specifically, for example, a drying method using the Marangoni effect called IPA Mist Dryer (IMD) can be used. In this drying method, the carrier 2 holding the substrate 4 is immersed in a pure water tank provided in the drying chamber 31, mist of IPA or vaporized IPA is continuously supplied to a water surface of the pure water tank, and a difference in surface tension generated on a surface of the substrate 4 passing through the water surface is used when the substrate 4 is raised or lowered or overflow or downflow of the water surface is caused.

Further, as another drying method, for example, drying by a centrifugal force called spin dryer can also be used. In this drying method, the carrier 2 holding the substrate 4 is set in a rotating rotor provided in the drying chamber 31, the carrier 2 and the substrate 4 are fixed by a retaining apparatus called a retainer, and then a centrifugal force generated by rotating the rotating rotor is used.

Further, as another drying method, for example, drying by steam cleaning called vapor dryer can be used. In this drying method, the drying chamber 31 is filled with saturated vapor formed by heating a solvent having small latent heat of evaporation (for example, IPA), the carrier 2 holding the substrate 4 at a temperature lower than a vapor temperature of the saturated vapor is set in the drying chamber 31, a surface of the carrier 2 and the substrate 4 is cleaned with IPA that aggregates and liquefies on a surface of the substrate 4, and when the carrier 2 and the substrate 4 are warmed to the same temperature as the IPA vapor, the aggregation and liquefaction of IPA on a surface of the carrier 2 and the substrate 4 is stopped, and the carrier 2 and the substrate 4 are dried.

As still another drying method, N₂ blow drying using N₂ can also be used. In any of the drying methods, the drying chamber 31 is isolated so as not to be affected by the vertical actuator 14 and the first actuator 12 that convey the carrier 2 holding the substrate 4. By the above, it is possible to suppress contamination in the drying module 6 due to particles generated from the vertical actuator 14 and the first actuator 12. Note that the first actuator 12 and the vertical actuator 14 may be arranged below the drying chamber 31 on the rear side in the first direction so as to be separated from the drying chamber 31. Further, in ae case where only conveyance in the vertical direction is required, the drying module 6 does not need to include the first conveyor 11.

The chemical module 7 includes at least one module. As illustrated in FIGS. 1 and 2, the chemical module 7 includes, for example, a first chemical module 7a, a second chemical module 7b, a third chemical module 7c, and a fourth chemical module 7d. In the chemical module 7, various types of liquid chemical cleaning such as ammonium hydroxidehydrogen peroxide mixture (APM) cleaning, sulfuric acidhydrogen peroxide mixture (SPM) cleaning, hydrochloric acidhydrogen peroxide mixture (HPM) cleaning, and diluted hydrofluoric acid (DHF) cleaning, and various types of liquid chemical processing such as etching and resist peeling are performed. These types of liquid chemical processing can be optionally combined depending on a type of liquid chemical processing for the substrate 4. The chemical modules 7a, 7b, 7c, and 7d are configured to be detachably connected in the second direction. By the above, it is possible to flexibly respond to the need for changing a processing process, and expandability is enhanced.

As illustrated in FIGS. 3, 5, and 9, the chemical module 7 includes a liquid chemical tank 32 (second tank) for performing liquid chemical cleaning and a cleaning tank 34 (first tank) for performing pure water cleaning (rinsing). The liquid chemical tank 32 is arranged on the rear side in the first direction, and the cleaning tank 34 is arranged on the front side in the first direction. That is, the liquid chemical tank 32 and the cleaning tank 34 are arranged in the first direction. By the above, since a width of the chemical module 7 in the second direction is narrowed, the substrate processing apparatus 1 can be downsized. Note that the configuration may be such that the liquid chemical tank 32 is arranged on the front side in the first direction, and the cleaning tank 34 is arranged on the rear side in the first direction. Further, since a common exhaust duct 29 for exhausting liquid chemical vapor generated from the liquid chemical tank 32 can be arranged on the rear side in the first direction, maintenance of the substrate processing apparatus 1 becomes easy. The liquid chemical tank 32 stores various types of the liquid chemical described above. Pure water is stored in the cleaning tank 34. The liquid chemical tank 32 includes, for example, an inner tank in which the carrier 2 is immersed in liquid chemical, and an outer tank that recovers liquid chemical overflowing from an upper end of the inner tank. At a timing not related to conveyance operation of the carrier 2, an opening of the liquid chemical tank 32 is closed by a lid.

Two side walls 37 and 37 are provided on a side of the liquid chemical tank 32 in the second direction. That is, a side in the second direction of the liquid chemical tank 32 is partitioned with the side wall 37. By the above, it is possible to suppress contamination due to an atmosphere of liquid chemical stored in the liquid chemical tank 32 of the chemical module 7 located adjacently. At the same time, a rear wall 38 is provided behind the liquid chemical tank 32 in the first direction. The liquid chemical tank 32 is surrounded by two of the side walls 37 and 37 and the rear wall 38 in a U shape when viewed from the vertical direction.

For example, two side exhaust ducts 36 and 36 having a side exhaust port 36a can be arranged in an upper portion on a side of the liquid chemical tank 32. Two of the side exhaust ports 36a and 36a are located slightly lower than but at substantially the same height as an opening of the liquid chemical tank 32. The rear wall 38 is provided with a rear exhaust port 39a of a rear exhaust duct 39 (illustrated in FIG. 9). Two of the side exhaust ducts 36 and 36 and the rear exhaust duct 39 branch from the common exhaust duct 29 and are connected to the common exhaust duct 29. The rear exhaust port 39a is located above an opening of the liquid chemical tank 32. As described above, the side exhaust port 36a and the rear exhaust port 39a for exhausting liquid chemical vapor evaporated from the liquid chemical tank 32 are arranged around the liquid chemical tank 32. By the above, liquid chemical vapor generated from the liquid chemical tank 32 can be prevented from diffusing into a processing space in the chemical module 7, and contamination of the substrate 4 conveyed in the processing space in the chemical module 7 can be suppressed.

Each of the chemical modules 7 includes the first conveyor 11 that conveys the carrier 2 in the first direction and the vertical conveyor 13 that conveys the carrier 2 in the vertical direction. The vertical conveyor 13 includes the vertical actuator 14. The carrier 2 is supported by a pedestal 18 provided on one end side of the arm 16 having an inverted U-shape. Note that the carrier 2 has a flange portion 3 on an upper portion of the carrier 2, and as described later, a chuck portion 44 of the second conveyor 48 enables holding of the flange portion 3 in a disengageable manner. Further, the flange portion 3 of the carrier 2 can be configured to be supported by the pedestal 18. Further, the arm 16 can also have a D-shape.

The other end side of the arm 16 is attached to the vertical actuator 14. The vertical actuator 14 is an electric linear actuator, and includes, for example, a screw shaft that moves the arm 16, a motor that rotates the screw shaft, a power supply, and a control unit that controls the motor. When the arm 16 is moved downward by the vertical actuator 14 in a state where the carrier 2 is located immediately above the liquid chemical tank 32 or the cleaning tank 34, the carrier 2 holding a plurality of the substrates 4 is immersed in liquid chemical in the liquid chemical tank 32 or cleaning liquid in the cleaning tank 34. When the arm 16 is moved upward by the vertical actuator 14 in a state where the carrier 2 is immersed in the liquid chemical or the cleaning liquid, the carrier 2 holding a plurality of the substrates 4 is pulled up from the liquid chemical or the cleaning liquid. Therefore, when the arm 16 is moved in the vertical direction by the vertical actuator 14 in a state where the carrier 2 is located immediately above the liquid chemical tank 32 or the cleaning tank 34, the carrier 2 holding a plurality of the substrates 4 is pulled up from or immersed in liquid chemical in the liquid chemical tank 32 or cleaning liquid in the cleaning tank 34.

The first conveyor 11 includes the first actuator 12. The vertical actuator 14 is attached to the first actuator 12. The first actuator 12 is an electric linear actuator, and includes, for example, a screw shaft that moves the vertical actuator 14, a motor that rotates the screw shaft, a power supply, and a control unit that controls the motor. When the arm 16 moves to the rear side in the first direction by the first actuator 12 in a state where the arm 16 has moved upward, the carrier 2 holding a plurality of the substrates 4 is conveyed to immediately above the liquid chemical tank 32. When the arm 16 is moved to the front side in the first direction by the first actuator 12 in a state where the arm 16 is positioned at a pull-up position, the carrier 2 holding a plurality of the substrates 4 is conveyed to immediately above the cleaning tank 34. Therefore, when the arm 16 is moved in the first direction by the first actuator 12 in a state where the arm 16 is positioned at the pull-up position, the carrier 2 holding a plurality of the substrates 4 is conveyed between immediately above the liquid chemical tank 32 and immediately above the cleaning tank 34.

The first actuator 12 and the vertical actuator 14 are arranged outside and below on a side of an opening of the liquid chemical tank 32 with the side exhaust duct 36 interposed between them. That is, by downflow from the fan filter unit 24 and exhaust of the side exhaust duct 36, the liquid chemical tank 32 and the cleaning tank 34 are isolated so as not to be affected by the first actuator 12 and the vertical actuator 14. By the above, a large separation distance can be secured between the first actuator 12 and the vertical actuator 14 and an opening of the liquid chemical tank 32, so that contamination in the chemical module 7 by particles generated from the first actuator 12 and the vertical actuator 14 can be suppressed. Note that the configuration may be such that two of the side exhaust ducts 36 and 36 are eliminated, and exhaust is performed only by the rear exhaust duct 39.

Next, the second conveyance mechanism 9 will be described with reference to FIGS. 1, 2, 4, 8, and 9.

As illustrated in FIG. 1, the second conveyance mechanism 9 is arranged in an upper portion on the rear side in the first direction in the loading module 5, the chemical module 7, the drying module 6, and the unloading module 8. As illustrated in FIG. 4, the second conveyance mechanism 9 has, for example, a configuration in which a plurality of second conveyance accommodation units 40 and second actuators 41 are connected in the second direction. Each of the second conveyance accommodation units 40 is configured as a part of each of the casings 20 of the loading module 5, the chemical module 7, the drying module 6, and the unloading module 8, for example. That is, the second conveyance accommodation unit 40 is configured integrally with the casing 20. Further, the second conveyance accommodation unit 40 can also be configured as a separate box-shaped member. Although FIGS. 2 and 4 illustrate a mode in which the second conveyance accommodation unit 40 is separated from the casing 20 for easy understanding of the configuration of the second conveyance accommodation unit 40, the second conveyance accommodation unit 40 may be an integral member constituting a part of the casing 20 or may be configured as a separate member. The second conveyance accommodation unit 40 and the second actuator 41 are configured to be detachably connected in the second direction.

As illustrated in FIG. 4, the second conveyance mechanism 9 includes a plurality of the second conveyance accommodation units 40 and at least one of the second conveyor 48. The number of the second conveyors 48 arranged in the second conveyance mechanism 9 is appropriately increased or decreased according to the number of the second conveyance accommodation units 40 connected. The second conveyor 48 includes the second actuator 41. The second actuator 41 is accommodated in the second conveyance accommodation unit 40. The first actuator 12 and the vertical actuator 14 are accommodated in the chemical module 7, and the second actuator 41 is accommodated in the second conveyance accommodation unit 40. By the above, since the first actuator 12, the vertical actuator 14, and the second actuator 41 are separately accommodated, contamination in the chemical module 7 can be suppressed.

The second actuator 41 is, for example, an electric linear actuator. The second actuator 41 is, for example, a rack-and-pinion, and includes a plate-like guide portion having a gear cut rack, a circular gear called a pinion, a motor that rotates the circular gear, a power supply, and a control unit that controls the motor. The flat plate shaped guide portion has a plurality of guide pieces, and a plurality of the guide pieces can be configured to be detachably connected in the second direction.

As illustrated in FIG. 9, the second conveyor 48 includes a rotary actuator 42 connected to the second actuator 41 via a link portion 46. The rotary actuator 42 is, for example, an electric rotary actuator, and includes a motor that rotates two of rotating arm portions 43 and 43, a power supply, and a control unit that controls the motor. The rotary actuator 42 can also be an actuator driven by hydraulic pressure or pneumatic pressure. The second actuator 41 and the liquid chemical tank 32 are separated by the rear wall 38. By the above, contamination in the chemical module 7 caused by the second actuator 41 can be suppressed.

The rotating arm portion 43 extends in the first direction through an opening 38a formed in the rear wall 38. The rotating arm portion 43 is movable in the second direction through a gap 37a formed in the side wall 37. The chuck portion 44 is provided on the front side of the rotating arm portion 43. The chuck portion 44 is configured to be located immediately above the cleaning tank 34. By the above, it is possible to suppress contamination in the chemical module 7 due to the carrier 2 held by the chuck portion 44 being conveyed on different types of the liquid chemical tanks 32.

The chuck portion 44 has a U-shape in the side view (that is, when viewed from the second direction). Two of the chuck portions 44 and 44 hold the flange portion 3 of the carrier 2 by sandwiching the flange portion 3 of the carrier 2 from both sides as the rotating arm portion 43 rotates. The holding of the flange portion 3 of the carrier 2 is released as two of the chuck portions 44 and 44 rotate in the direction of separating from each other. Therefore, two of the chuck portions 44 and 44 can be disengaged from the flange portion 3 of the carrier 2.

Since the second actuator 41 is accommodated in the second conveyance accommodation unit 40, the liquid chemical tank 32 and the cleaning tank 34 are isolated so as not to be affected by the second actuator 41. That is, the second actuator 41 is isolated from the liquid chemical tank 32 and the cleaning tank 34. By the above, contamination due to particles generated from the second actuator 41 can be suppressed.

The specific embodiment and the numerical value of the present invention are described. However, the present invention is not limited to the above embodiment, and can be implemented with various modifications made within the scope of the present invention.

For example, in the above-described embodiment, the first actuator 12 and the vertical actuator 14 are arranged in a lower portion on a side (lower portion in the second direction), but may be arranged on the first direction side as necessary.

The number and combination of modules in the substrate processing apparatus 1 can be appropriately designed as necessary, and for example, the chemical module 7 and the drying module 6 can be alternately arranged.

The present invention and embodiment are summarized as described below.

The substrate processing apparatus 1 according to an aspect of the present invention includes:
the chemical module 7 including the liquid chemical tank 32 for processing the substrate 4 held by the carrier 2 with liquid chemical and the cleaning tank 34 for cleaning the substrate 4 held by the carrier 2,
the chemical module 7 includes:
   the first conveyor 11 that conveys the carrier 2 in the first direction in which the liquid chemical tank 32 and the cleaning tank 34 can be placed;
   the vertical conveyor 13 that conveys the carrier 2 in the vertical direction intersecting the first direction; and
   the second conveyor 48 that conveys the carrier 2 in the second direction intersecting the first direction and the vertical direction,
   the first conveyor 11, the second conveyor 48, and the vertical conveyor 13 are driven by the first actuator 12, the second actuator 41, and the vertical actuator 14, respectively, and
   the first actuator 12, the second actuator 41, and the vertical actuator 14 are isolated from the liquid chemical tank 32 and the cleaning tank 34.

According to the above configuration, by conveyance in the first direction by the first conveyor 11 and conveyance in the second direction by the second conveyor 48, another ones of the liquid chemical tank 32 and the cleaning tank 34 located adjacent to each other are isolated so as not to be affected by liquid chemical attached to the carrier 2 being conveyed, so that contamination by the liquid chemical can be suppressed. Further, since the actuators 12, 41, and 14 for driving the conveyors 11, 48, and 13 that convey the carrier 2 are isolated so as not to be affected by the liquid chemical tank 32 and the cleaning tank 34, contamination by particles of the carrier 2 in the chemical module 7 can be suppressed. Further, since the liquid chemical tank 32 and the cleaning tank 34 are arranged in the first direction, the width of the chemical module 7 in the second direction is narrowed, so that the substrate processing apparatus 1 can be downsized. Further, since the apparatus for processing each step is modularized, it is possible to flexibly respond to the change needs by connecting another ones of the modules 5, 6, and 8 to the chemical module 7.

Further, in the substrate processing apparatus 1 of one embodiment,
the chemical module 7 is configured to be detachably connected in the second direction.

According to the above embodiment, it is possible to flexibly respond to the need for changing the processing process, and the expandability is enhanced.

Further, in the substrate processing apparatus 1 of one embodiment, The first actuator 12 and the vertical actuator 14 are arranged below openings of the liquid chemical tank 32 and the cleaning tank 34.

According to the above embodiment, it is possible to suppress contamination in the chemical module 7 by particles generated from the first actuator 12 and the vertical actuator 14.

Further, the substrate processing apparatus 1 of one embodiment further includes:
the loading module 5 that loads the carrier 2 holding the substrate 4, the drying module 6 that dries the substrate 4 held by the carrier 2, or the unloading module 8 that unloads the carrier 2 holding the substrate 4, and
the loading module 5, the drying module 6, and the unloading module 8 are configured to be detachably connected in the second direction.

According to the above embodiment, it is possible to flexibly respond to the need for changing the processing process, and the expandability is enhanced.

Further, in the substrate processing apparatus 1 of one embodiment,
the second actuator 41 and the liquid chemical tank 32 are separated by the rear wall 38.

According to the above embodiment, it is possible to suppress contamination in the chemical module 7 by particles generated from the second actuator 41.

Further, in the substrate processing apparatus 1 of one embodiment,
a side of the liquid chemical tank 32 in the second direction is partitioned with the side wall 37.

According to the above embodiment, it is possible to suppress contamination due to the atmosphere of liquid chemical stored in the liquid chemical tank 32 of the chemical modules 7 adjacent to each other.

Further, in the substrate processing apparatus 1 of one embodiment,
the liquid chemical tank 32 is arranged on the rear side in the first direction, and the cleaning tank 34 is arranged on the front side in the first direction.

According to the above embodiment, since the exhaust duct 39 for exhausting liquid chemical vapor generated from the liquid chemical tank 32 can be arranged on the rear side in the first direction, maintenance of the substrate processing apparatus 1 becomes easy.

Note that, in the above embodiment, the case where a plurality of the substrates 4 are held by the carrier 2 is described, but the present invention is not limited to such a case, and may be carrierless. For example, a plurality of the substrates 4 may be directly held by the chuck portion 44 or the pedestal 18.

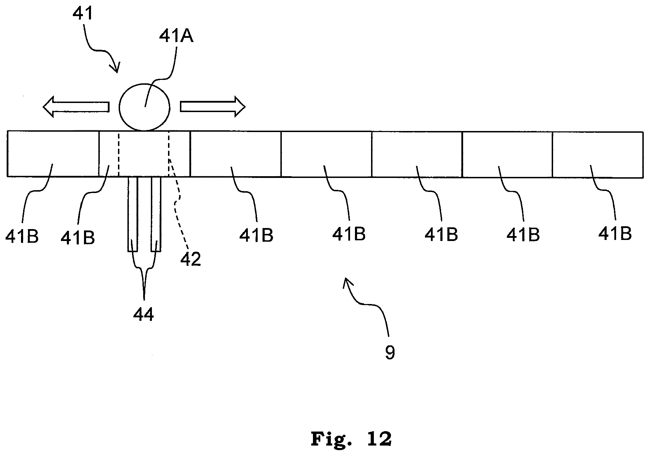

Here, the second actuator 41 illustrated in FIG. 4 will be described with reference to FIG. 12. FIG. 12 is a schematic view of a case where the second conveyance mechanism 9 is viewed in plan view. In FIG. 12, illustration of the second conveyance accommodation unit 40 is omitted.

As illustrated in FIG. 12, the second actuator 41 includes an actuator main body portion 41A and a plurality of rails 41B. The actuator main body portion 41A is a drive unit that moves in the left-right direction (second direction) along the rail 41B. The rail 41B is a member that movably supports the actuator main body portion 41A, and is provided for each module. A plurality of the rails 41B are arranged in the second direction to form a continuous track, so that a plurality of modules are connected.

In a case where the second actuator 41 is a rack-and-pinion, the actuator main body portion 41A is a drive unit including a motor, a speed reduction portion, a pinion gear, and the like, and the rail 41B is a rack.

As illustrated in FIG. 12, only one of the actuator main body portions 41A is provided for a plurality of the rails 41B, and is common among a plurality of modules. By the above, it is possible to reduce the cost when a plurality of modules are connected. Note that the number of the actuator main body portions 41A is not limited to one, and a plurality of the actuator main body portions 41A may be provided in a case where the loading module 5 (loader) and the unloading module 8 (unloader) are separately arranged on the left and right as in the embodiment, for example.

While a plurality of reference numerals 41 are attached in FIG. 4, there are a plurality of the rails 41B of the second actuator 41.

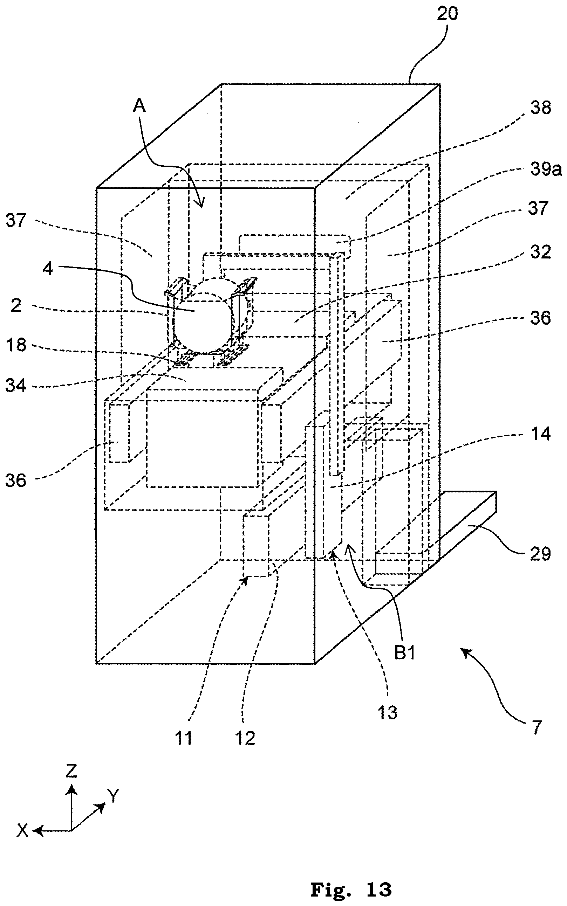

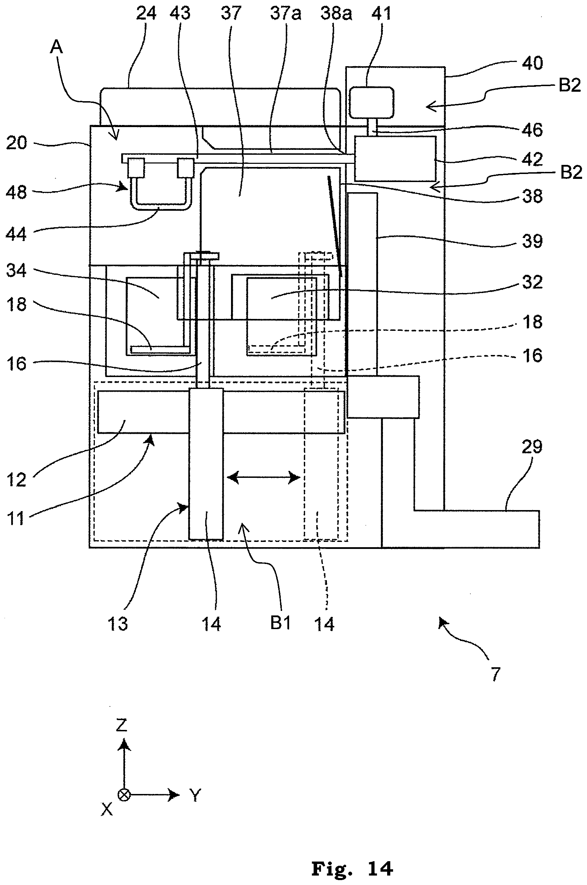

Next, a relationship between a drive space in which the actuators 12, 14, 41, and 42 are arranged and a processing space in which the substrate 4 is processed will be described with reference to FIGS. 13 and 14.

FIG. 13 is a perspective view illustrating the chemical module 7, and FIG. 14 is a diagram for explaining the movement of the first conveyor 11 in the chemical module 7.

As illustrated in FIGS. 13 and 14, the casing 20 forms a processing space A for processing the substrate 4. The processing space A is a space in which the liquid chemical tank 32 and the cleaning tank 34 are arranged inside, and a plurality of the substrates 4 are conveyed in the front-rear direction (first direction) and the horizontal direction (second direction). The processing space A is surrounded by a pair of the side walls 37 and the rear wall 38.

As illustrated in FIGS. 13 and 14, the casing 20 forms a first drive space B1. The first drive space B1 is a space for arranging the first actuator 12 and the vertical actuator 14. The first drive space B1 is formed on a side in the second direction of and below openings of the liquid chemical tank 32 and the cleaning tank 34.

As illustrated in FIG. 14, the casing 20 forms a second drive space B2. The second drive space B2 is a space for arranging the second actuator 41 and the rotary actuator 42. The second drive space B2 is formed behind the processing space A in the first direction, that is, behind the rear wall 38.

As the actuators 12, 14, 41, and 42 are arranged in the drive spaces B1 and B2, the actuators 12, 14, 41, and 42 can be isolated from the processing space A. By the above, a foreign matter generated from the actuators 12, 14, 41, and 42 can be prevented from entering the processing space A, and contamination in the chemical module 7 can be suppressed.

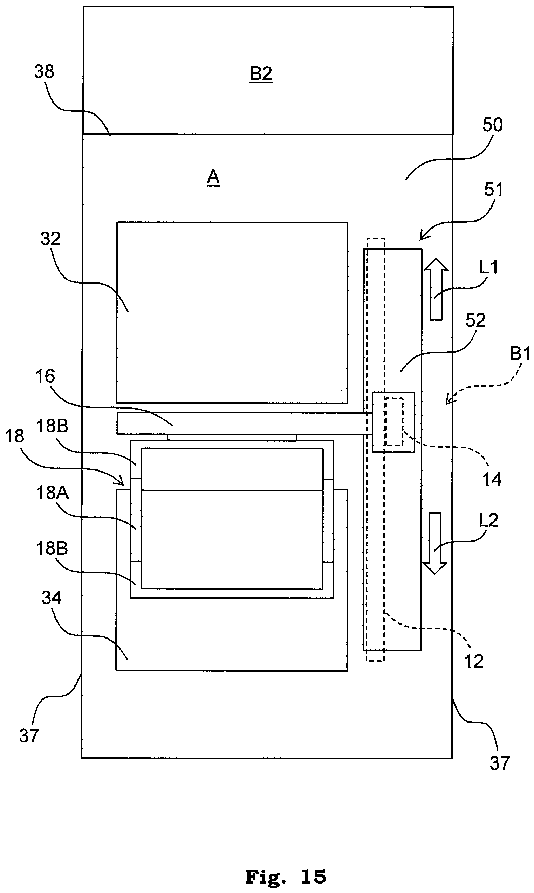

As illustrated in FIGS. 13 and 14, the second drive space B2 and the processing space A are isolated by the rear wall 38, whereas as illustrated in FIG. 13, the first drive space B1 and the processing space A are isolated by the side exhaust duct 36. Not limited to such a case, for example, the first drive space B1 and the processing space A may be isolated by providing a wall portion that separates the first drive space B1 and the processing space A. An example of the above will be described with reference to FIG. 15.

FIG. 15 is a schematic plan view illustrating the processing space A according to a variation. As illustrated in FIG. 15, a bottom wall 50 is provided so as to surround the liquid chemical tank 32 and the cleaning tank 34. The bottom wall 50 is a wall portion constituting a bottom portion of the processing space A. An opening 51 is formed in a part of the bottom wall 50, and a movable wall 52 is provided below the opening 51. The movable wall 52 is arranged so as to cover the opening 51, and moves integrally with the arm 16 supporting the pedestal 18 in the front-rear direction (arrows L1 and L2). The movable wall 52 has a long shape in the front-rear direction, and has a length for covering the entire opening 51 at all times in a range where the arm 16 moves. The arm 16 extends downward so as to penetrate the movable wall 52 and is connected to the vertical actuator 14. The arm 16 is arranged in close contact with a through hole of the movable wall 52 through which the arm 16 penetrates. In the example illustrated in FIG. 15, the side exhaust duct 36 is not provided.

According to the configuration illustrated in FIG. 15, by providing the movable wall 52 through which the arm 16 is inserted, it is possible to physically separate the processing space A and the first drive space B1 while enabling the arm 16 to move in the front-rear direction. By the above, contamination in the chemical module 7 can be more reliably suppressed.

Note that, similarly, the rear wall 38 may be provided with a movable wall through which the rotating arm portion 43 is inserted.

Further, in the example illustrated in FIG. 15, the pedestal 18 includes an upper step portion 18A and a lower step portion 18B in an outer frame portion constituting a space for accommodating the carrier 2. The upper step portion 18A is a portion protruding upward more than the lower step portion 18B, and has a function of supporting the flange portion 3 of the carrier 2 from below. The lower step portion 18B is a portion located below the upper step portion 18A, and forms a gap for arranging a tip of the chuck portion 44 (claw shape) of the second conveyor 48. By providing the lower step portion 18B, even in a state where the flange portion 3 of the carrier 2 is supported by the upper step portion 18A, the chuck portion 44 of the second conveyor 48 can support the flange portion 3 of the carrier 2 at a position different from the upper step portion 18A. By the above, the chuck portion 44 and the pedestal 18 can hold the carrier 2 without interfering with each other, and the carrier 2 can be easily passed between the chuck portion 44 and the pedestal 18.

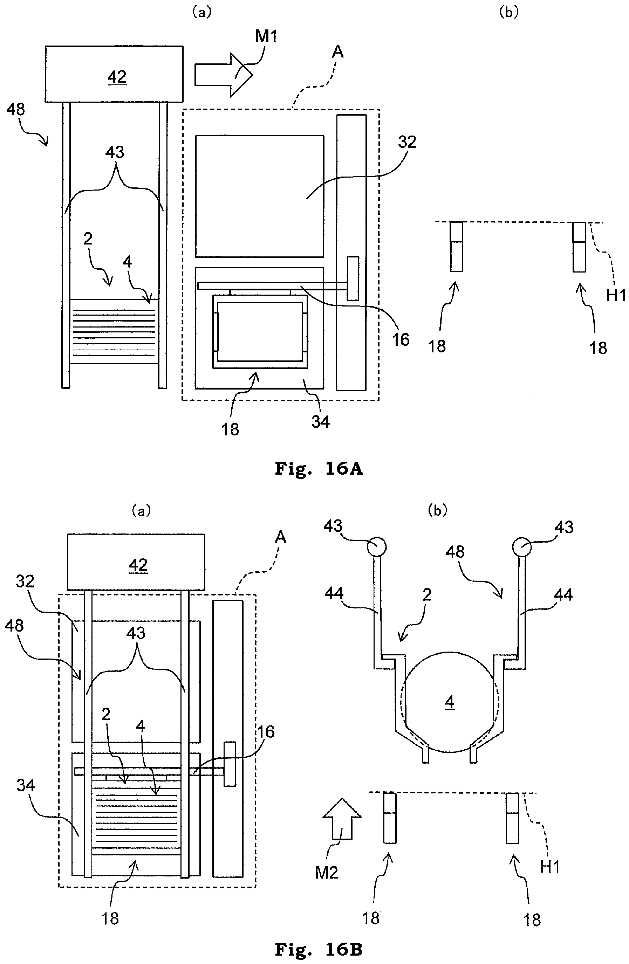

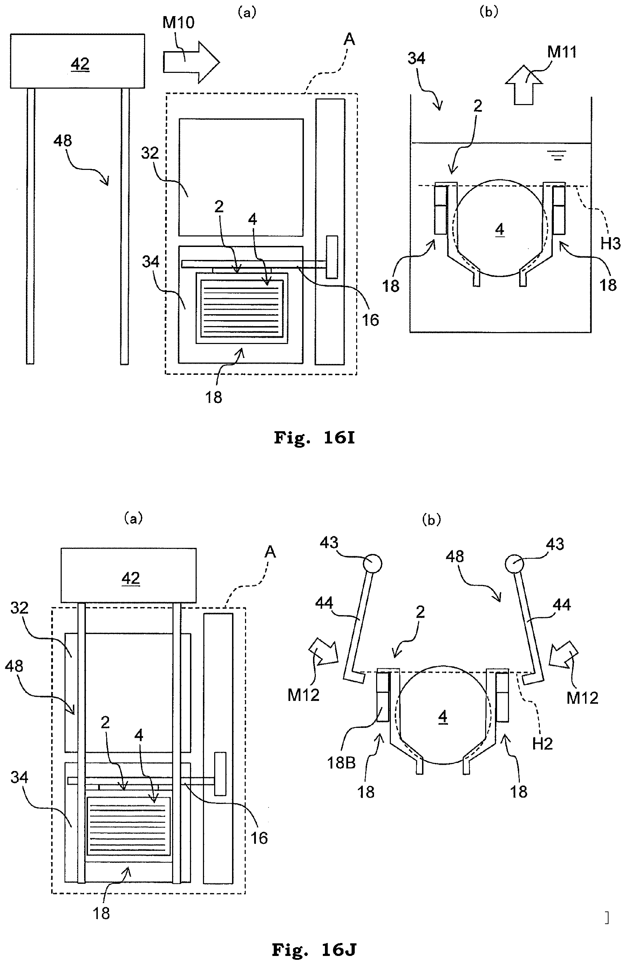

Next, an example of operation of the substrate processing apparatus 1 will be described with reference to FIGS. 16A to 16L.

FIGS. 16A to 16L are schematic diagrams for explaining an example of operation of the substrate processing apparatus 1, in which (a) is a plan view of the processing space A, and (b) is a side view illustrating a peripheral configuration of the pedestal 18 and the substrate 4.

As illustrated in FIG. 16A, first, in the processing space A, the pedestal 18 stands by above the cleaning tank 34. As illustrated in (b), the pedestal 18 is arranged above the cleaning tank 34 and at an intermediate position H1 which is a height position at which the pedestal 18 does not interfere with the chuck portion 44 of the second conveyor 48. In a state where the pedestal 18 stands by, as illustrated in (a), the second conveyor 48 moves the carrier 2 holding a plurality of the substrates 4 in the horizontal direction (arrow M1).

As illustrated in FIG. 16B, the second conveyor 48 moves the carrier 2 holding the substrate 4 to above the pedestal 18. After the above, the pedestal 18 is raised from the intermediate position H1 (arrow M2), and the carrier 2 is held by the pedestal 18.

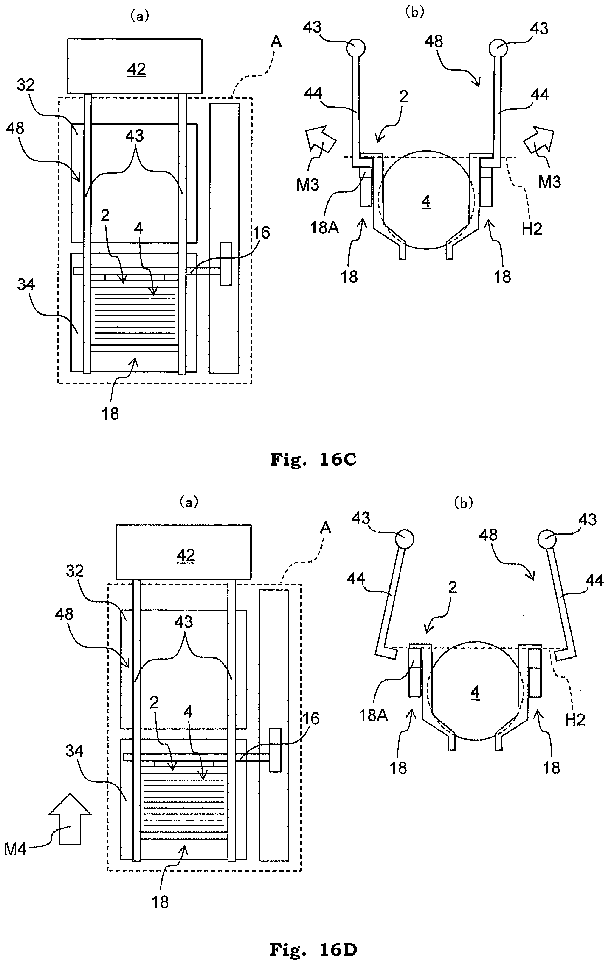

As illustrated in FIG. 16C, the upper step portion 18A of the pedestal 18 abuts on and supports the flange portion 3 of the carrier 2 from below. As described with reference to FIG. 15, the chuck portion 44 supports the flange portion 3 of the carrier 2 at a position different from the upper step portion 18A of the pedestal 18, and does not interfere with the pedestal 18. After the above, the chuck portion 44 is rotated in an opening direction (arrow M3) to release holding of the substrate 4. By the above, as illustrated in FIG. 16D, the carrier 2 is passed from the chuck portion 44 to the pedestal 18.

The pedestal 18 holds the carrier 2 at an elevated position H2 higher than the intermediate position H1. In this state, the pedestal 18 holding the carrier 2 is moved rearward toward the liquid chemical tank 32 (arrow M4) . Since the chuck portion 44 is opened in a direction away from the pedestal 18, the chuck portion 44 does not interfere with the movement of the carrier 2 and the pedestal 18.

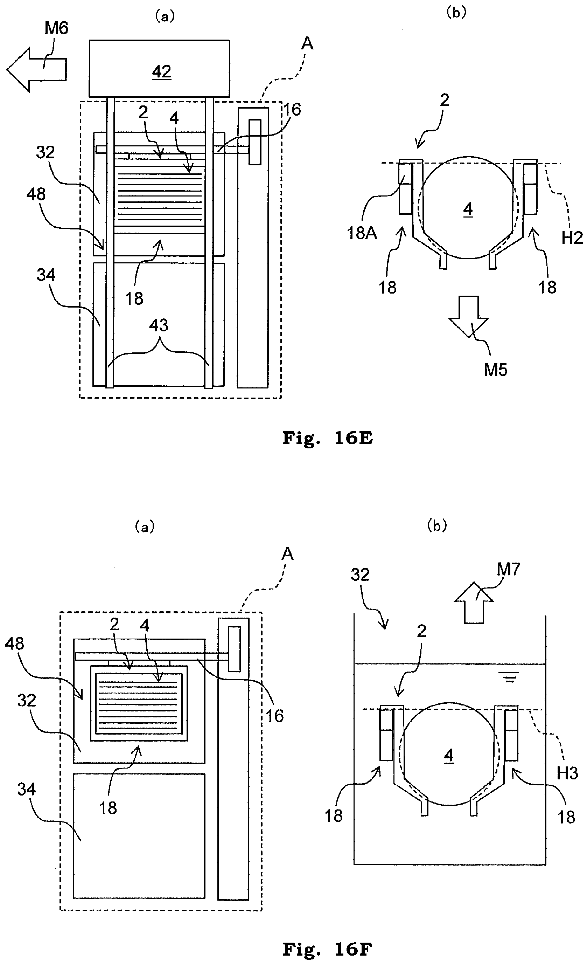

As illustrated in FIG. 16E, the carrier 2 and the pedestal 18 move to above the liquid chemical tank 32 and stop. In this state, the carrier 2 and the pedestal 18 are lowered (arrow M5), and the substrate 4 is immersed in liquid chemical stored in the liquid chemical tank 32. At this time, since the chuck portion 44 of the second conveyor 48 is above the cleaning tank 34 and does not interfere with the carrier 2 or the pedestal 18, the chuck portion 44 can be retracted in the horizontal direction (arrow M6). Note that the second conveyor 48 may be kept on standby above the cleaning tank 34 without being retracted.

As illustrated in FIG. 16F, the pedestal 18 is lowered to a lowered position H3 which is a height position at which a plurality of the substrates 4 are immersed in liquid chemical. By immersing the substrate 4 in liquid chemical, processing such as etching can be performed on a surface of the substrate 4.

As liquid chemical in the liquid chemical tank 32, any liquid may be used as long as a surface of the substrate 4 can be processed. For example, in a case of organic liquid chemical, an amine solution such as NMP or monoethanolamine, acetone, or the like may be used, and in a case of inorganic liquid chemical, SC1 (APM), SC2 (HPM), SPM, hydrofluoric acid (HF), buffered hydrofluoric acid (BHF), or the like may be used. Further, one kind of liquid may be used alone, or two or more kinds of liquid may be used in combination.

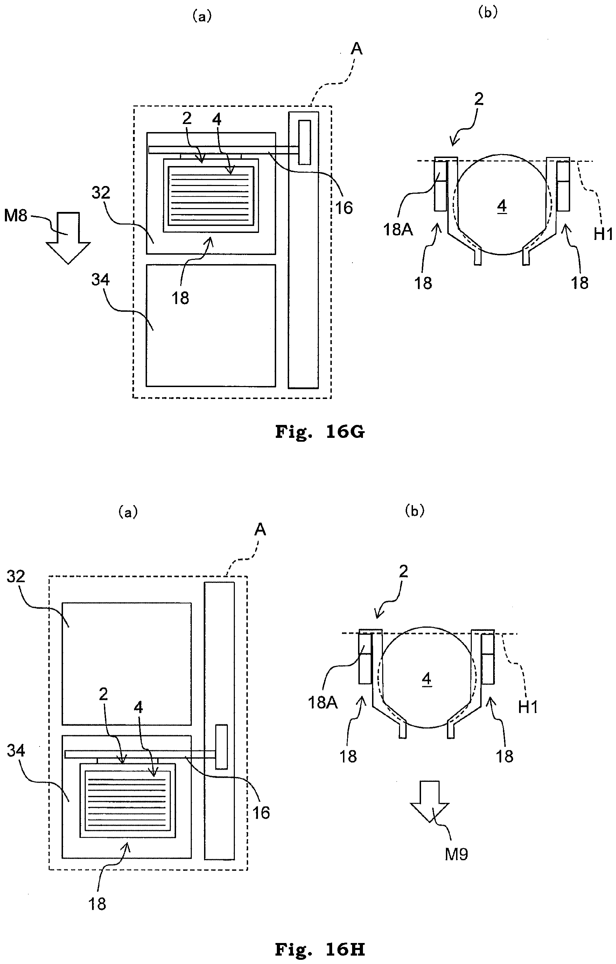

When liquid chemical processing of the substrate 4 is completed, the carrier 2 and the pedestal 18 are raised (arrow M7), and the substrate 4 is pulled up. As illustrated in FIG. 16G, the pedestal 18 rises to the intermediate position H1. In this state, the carrier 2 and the pedestal 18 are moved forward toward the cleaning tank 34 (arrow M8).

As illustrated in FIG. 16H, the carrier 2 and the pedestal 18 move to above the cleaning tank 34 and stop. After the above, the carrier 2 and the pedestal 18 are lowered (arrow M9), and the substrate 4 is arranged inside the cleaning tank 34.

As illustrated in FIG. 161, in a state where the pedestal 18 is lowered to the lowered position H3, the substrate 4 is immersed in cleaning water such as pure water stored in the cleaning tank 34. By the above, a surface of the substrate 4 to which liquid chemical adheres can be rinsed. Not limited to the case of immersing in cleaning water, cleaning water may be jetted to the substrate 4. As the rinse processing, any liquid and method may be used as long as liquid chemical adhering to a surface of the substrate 4 can be replaced to a state that does not cause a problem in next processing. For example, a protic solvent, water, alcohol such as IPA or ethanol, or an amine solution such as NMP or monoethanolamine may be used. Further, one kind of liquid may be used alone, or two or more kinds of liquid may be used in combination.

While rinse processing of the substrate 4 is performed, the second conveyor 48 that has been retracted can be returned to above the cleaning tank 34 (arrow M10). After the chuck portion 44 of the second conveyor 48 is positioned above the cleaning tank 34, the carrier 2 that holds the substrate 4 for which the rinse processing is completed and the pedestal 18 are raised (arrow M11).

As illustrated in FIG. 16J, the pedestal 18 ascends to the elevated position H2 which is a position for passing the carrier 2 to the chuck portion 44. In this state, the chuck portion 44 is rotated in a closing direction (arrow M12), and a plurality of the substrates 4 are held by the chuck portion 44. The chuck portion 44 is inserted into a gap between the lower step portion 18B of the pedestal 18 and the flange portion 3 of the carrier 2, and supports the flange portion 3 from below.

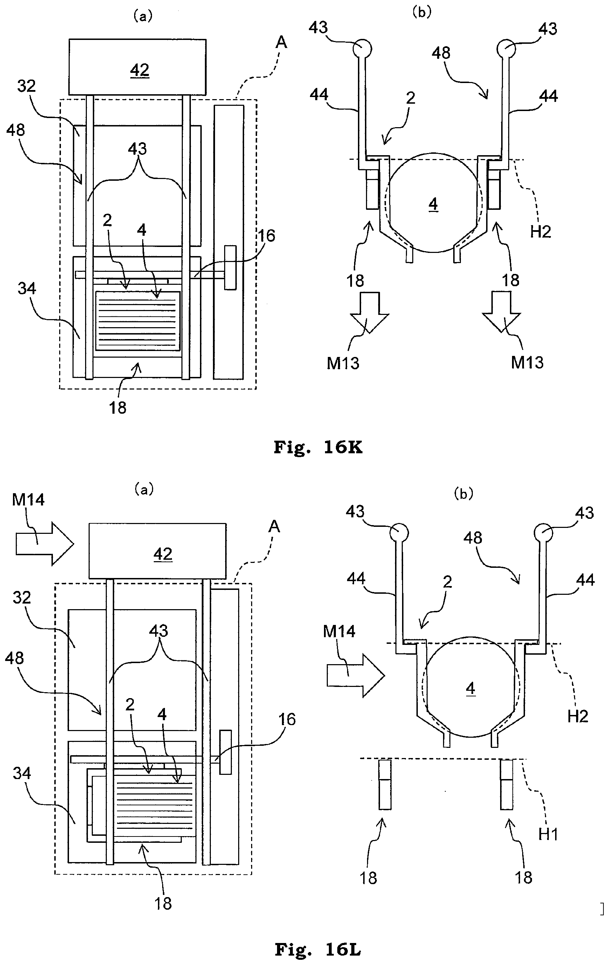

After the above, as illustrated in FIG. 16K, the pedestal 18 is lowered in a state where the carrier 2 is held by the chuck portion 44 (arrow M13). By the above, holding of the carrier 2 by the pedestal 18 is released, and the carrier 2 is passed from the pedestal 18 to the chuck portion 44.

As illustrated in FIG. 16L, the pedestal 18 retracts to the intermediate position H1 where the pedestal 18 does not interfere with the carrier 2 or the chuck portion 44. For this reason, the second conveyor 48 having the chuck portion 44 holding the carrier 2 can move toward a next one of the chemical modules 7 (arrow M14).

According to operation illustrated in FIGS. 16A to 16L, by using the liquid chemical tank 32 and the cleaning tank 34 arranged in the front-rear direction (first direction) in the processing space A of the chemical module 7, the substrate 4 is conveyed in the front-rear direction (first conveyance step) and liquid chemical processing and rinse processing are executed on the substrate 4, and when both pieces of processing are completed, the substrate 4 can be conveyed in the horizontal direction (second direction) toward a next one of the chemical modules 7 (second conveyance step). By executing the first conveyance step and the second conveyance step, the substrate 4 for which processing such as etching processing has been completed can be manufactured.

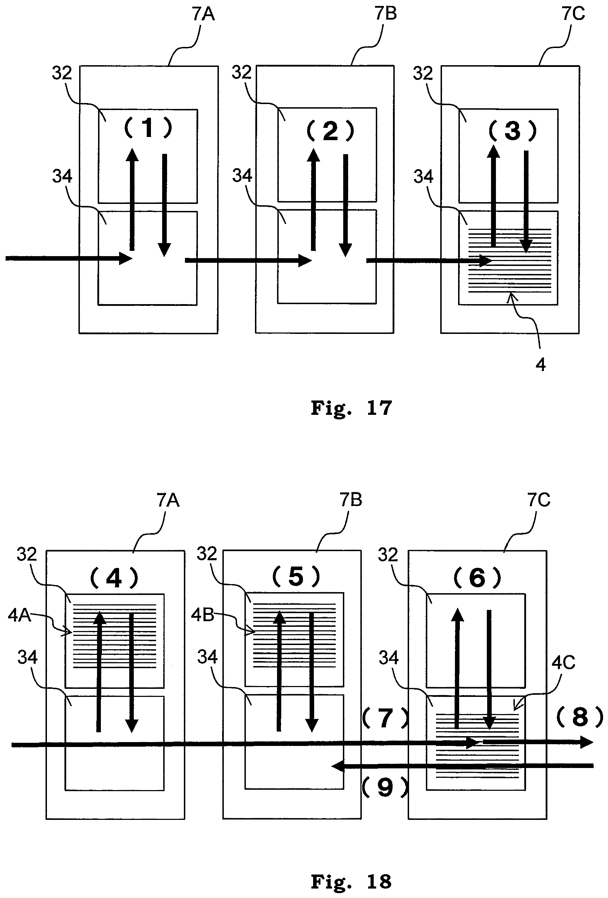

In a case where the substrates 4 are processed in one batch, operation illustrated in FIGS. 16A to 16L is preferably executed for each module for one batch of the substrates 4. As illustrated in a schematic plan view of FIG. 17, when the substrate 4 is processed in a chemical module 7A (1), the substrate 4 is conveyed to a next chemical module 7B and another kind of processing is executed (2), and the substrate 4 is conveyed to a next chemical module 7C and another kind of processing is executed (3). Note that the order of the operations (1) to (3) is not particularly limited, and may be a random order. That is, it is not necessary to convey the substrate 4 in the order in which the chemical modules 7A, 7B, and 7C are arranged and to execute processing in each module.

In a case where the substrates 4 are processed in a plurality of batches, as illustrated in a schematic plan view of FIG. 18, while a substrate 4A is processed by the chemical module 7A (4), and while a substrate 4B which is another one is processed by the chemical module 7B which is another one (5), a substrate 4C which is another one can be further processed by the chemical module 7C which is another one (6). Since the first conveyor 11 and the vertical conveyor 13 are provided in each of the modules 7A, 7B, and 7C, conveyance and processing of a substrate can be executed in parallel in each of the modules 7A, 7B, and 7C. Note that the order of the operations (4) to (6) is not particularly limited, and may be a random order. For example, the substrate 4C may be conveyed to the chemical module 7C, then the substrate 4A may be conveyed to the chemical module 7A, then the substrate 4B may be conveyed to the chemical module 7B, and the substrates 4A, 4B, and 4C may be processed by the modules 7A, 7B, and 7C, respectively.

As illustrated in FIG. 18, when the substrates 4A and 4B are located away from above the cleaning tank 34, the chuck portion 44 (not illustrated) of the second conveyor 48 does not interfere with the substrates 4A and 4B, the carrier 2 (not illustrated in FIGS. 17 and 18), or the pedestal 18, and can move in the horizontal direction through the chemical modules 7A and 7B (7). The second conveyor 48 that has moved to the chemical module 7C can receive the substrate 4C for which processing is completed and convey the substrate 4C to a next one of the chemical modules 7 (8). After the substrate 4C is passed to a next one of the chemical modules 7, the second conveyor 48 can move to a module in which processing of the substrates 4A and 4B is completed between the chemical modules 7A and 7B (9), receive a substrate for which processing is completed, and convey the substrate to a next one of the chemical modules 7.

According to the above operation, the substrates 4A, 4B, and 4C in a plurality of batches can be processed in parallel in each module, and the second conveyor 48 crossing the modules during the processing can be moved in the horizontal direction. By the above, it is possible to realize operation that cannot be realized by a configuration in which a plurality of tanks are arranged in a row in the horizontal direction as in a conventional substrate processing apparatus, and it is possible to greatly improve processing efficiency.

### (Operation and effect 1)

As described above, the chemical module 7 (substrate processing module) of the embodiment includes the cleaning tank 34 (first tank) and the liquid chemical tank 32 (second tank) that are arranged in the first direction and in which the substrate 4 can be placed, the first conveyor 11 that moves the substrate 4 in the first direction, and the second conveyor 48 that moves the substrate 4 in the second direction intersecting the first direction.

According to such a configuration, by providing the first conveyor 11 that conveys the substrate 4 in the first direction and the second conveyor 48 that conveys the substrate 4 in the second direction while arranging the cleaning tank 34 and the liquid chemical tank 32 in the first direction, the substrate 4 can be conveyed in different directions (MD direction and TD direction). By the above, it is possible to reduce an installation area of the entire apparatus as compared with a case where a plurality of tanks are arranged side by side only in one direction as in a conventional substrate processing apparatus. Further, by separately providing the first conveyor 11 and the second conveyor 48, it is possible to improve processing efficiency such a manner as to convey and process the separate substrates 4 by the first conveyor 11 and the second conveyor 48.

Further, the chemical module 7 of the embodiment further includes the vertical conveyor 13 that vertically moves the substrate 4, the vertical conveyor 13 is connected to the first conveyor 11, and the first conveyor 11 moves the vertical conveyor 13 in the first direction. According to such a configuration, a function of vertically moving the substrate 4 or a function of moving the substrate 4 in the first direction can be omitted in the second conveyor 48, and movement of the substrate 4 can be simplified.

Further, the chemical module 7 of the embodiment can be connected to another module (the loading module 5, the drying module 6, the chemical module 7, or the unloading module 8) in the second direction. By the above, the substrate 4 can be conveyed between a plurality of modules using the second conveyor 48.

Further, in the chemical module 7 of the embodiment, the second actuator 41 of the second conveyor 48 is used also in another module. According to such a configuration, it is possible to reduce the cost when connecting the chemical module 7 to another module.

Further, in the chemical module 7 of the embodiment, the second conveyor 48 includes the rail 41B extending in the second direction, and the rail 41B is arranged so as to be aligned with the rail 41B of another module in the second direction. According to such a configuration, modules can be connected to each other using a simple structure.

Further, the chemical module 7 of the embodiment further includes a pair of the side walls 37 that sandwich the cleaning tank 34 and the liquid chemical tank 32 in the second direction, and the side walls 37 have the gap 37a for allowing the second conveyor 48 to pass through. According to such a configuration, movement between modules of the second conveyor 48 can be realized with a simple configuration. Further, since size of the gap 37a can be kept to be large enough to allow the second conveyor 48 pass through, contamination between modules can be suppressed.

Further, in the chemical module 7 of the embodiment, the cleaning tank 34 is arranged on the front side in the first direction, the liquid chemical tank 32 is arranged on the rear side in the first direction, and the second conveyor 48 moves the substrate 4 above the cleaning tank 34. According to such a configuration, it is possible to reduce contamination between the liquid chemical tanks 32 between modules. Further, when an operator checks the inside of the chemical module 7 from the front, the substrate 4 conveyed by the second conveyor 48 is easily visually recognized.

In the chemical module 7 of the embodiment, another module connected to the chemical module 7 in the second direction is any one of the loading module 5, the unloading module 8, the drying module 6, and the chemical module 7. According to such a configuration, modules having various functions can be connected as another module.

Further, the substrate processing apparatus 1 according to the embodiment includes the chemical module 7 and another module (the loading module 5, the drying module 6, the chemical module 7, or the unloading module 8;) connected to the chemical module 7 in the second direction. According to such a configuration, it is possible to realize the substrate processing apparatus 1 having a small installation area and high processing efficiency.

Further, the method of manufacturing a substrate (substrate processing method) of the embodiment includes, in the chemical module 7 (substrate processing module), a first conveyance step of conveying the substrate 4 in the first direction in a manner moving between the cleaning tank 34 (first tank) and the liquid chemical tank 32 (second tank) arranged in the first direction, and a second conveyance step of conveying the substrate 4 in the second direction intersecting the first direction.

According to such a method, the substrate 4 can be conveyed in different directions (MD direction and TD direction) in the chemical module 7. By the above, it is possible to reduce an installation area of the entire apparatus and improve efficiency of processing as compared with a case where a plurality of tanks are arranged side by side only in one direction as in a conventional substrate processing apparatus. Note that the second conveyance step may be manually performed by an operator.

### (Operation and effect 2)

As described above, the chemical module 7 (substrate processing module) of the embodiment includes the cleaning tank 34 (first tank) and the liquid chemical tank 32 (second tank) that are arranged in the first direction and in which the substrate 4 can be placed, the first conveyor 11 that moves the substrate 4 in the first direction, the second conveyor 48 that moves the substrate 4 in the second direction intersecting the first direction, and the vertical conveyor 13 that is connected to the first conveyor 11 and vertically moves the substrate 4. Further, the first actuator 12 of the first conveyor 11 and the second actuator 41 of the second conveyor 48 are respectively arranged in the drive spaces B1 and B2 separated from the processing space A accessible to the cleaning tank 34 and the liquid chemical tank 32.

According to such a configuration, by providing the first conveyor 11 that conveys the substrate 4 in the first direction and the second conveyor that conveys the substrate 4 in the second direction while arranging the cleaning tank 34 and the liquid chemical tank 32 in the first direction, the substrate 4 can be conveyed in different directions (MD direction and TD direction). By the above, it is possible to reduce an installation area of the entire apparatus as compared with a case where a plurality of tanks are arranged side by side only in one direction as in a conventional substrate processing apparatus. Further, by arranging two of the actuators 12 and 41 in the drive spaces B1 and B2 separated from the processing space A, a foreign matter generated from the actuators 12 and 41 hardly enters the processing space A, and contamination in the chemical module 7 can be suppressed.

Further, in the chemical module 7 of the embodiment, the first actuator 12 is arranged in the first drive space B1, and the second actuator 41 is arranged in the second drive space B2. According to such a configuration, a space in a module can be effectively used by arranging the first actuator 12 and the second actuator 41 in the drive spaces B1 and B2, respectively.

Further, in the chemical module 7 of the embodiment, the first drive space B1 is provided on a side and below openings of the cleaning tank 34 and the liquid chemical tank 32, and the second drive space B2 is provided on the rear side in the first direction with respect to the processing space A. According to such a configuration, a space in the chemical module 7 can be effectively used.

Further, the chemical module 7 of the embodiment further includes the rear wall 38 provided behind the processing space A, and the second drive space B2 is provided behind the rear wall 38. According to such a configuration, by separating the processing space A and the first drive space B1 by the rear wall 38, a foreign matter generated from the first actuator arranged in the first drive space B1 hardly enters the processing space A, and contamination can be suppressed.

Further, in the chemical module 7 of the embodiment, the rear wall 38 forms the exhaust port 39a for exhausting the atmosphere of the processing space A to the outside. According to such a configuration, even in a case where a foreign matter enters the processing space A, the foreign matter can be exhausted to the outside through the exhaust port 39a.

Further, in the chemical module 7 of the embodiment, the second conveyor 48 includes the rotating arm portion 43 (arm) extending forward from the second drive space B2 and passing through the opening 38a provided in the rear wall 38, and the chuck portion 44 connected to the rotating arm portion 43 and arranged above the cleaning tank 34. According to such a configuration, the second conveyor 48 can be realized using a simple configuration. Further, since the opening 38a of the rear wall 38 only needs to have an area that allows the rotating arm portion 43 to pass through, a foreign matter generated from the second actuator 41 can be made less likely to enter the processing space A as the area of the opening 38a is kept to be minimum.

Further, in the chemical module 7 of the embodiment, the second drive space B2 can be connected to another module. According to such a configuration, since the second drive space B2 can be connected, modules can be easily connected to each other.

Further, in the chemical module 7 of the embodiment, the second conveyor 48 further includes the rotary actuator 42 that rotates the chuck portion 44 for holding the substrate 4, and the rotary actuator 42 is arranged in the second drive space B2. According to such a configuration, by arranging the rotary actuator 42 in the second drive space B2 together with the second actuator 41, a foreign matter generated from the rotary actuator 42 can be made less likely to enter the processing space A, and contamination can be suppressed.

Further, in the chemical module 7 of the embodiment, the vertical actuator 14 of the vertical conveyor 13 is arranged in the first drive space B1. According to such a configuration, by arranging the vertical actuator 14 in the first drive space B1 together with the first actuator 12, a foreign matter generated from the vertical actuator 14 can be made less likely to enter the processing space A, and contamination can be suppressed.

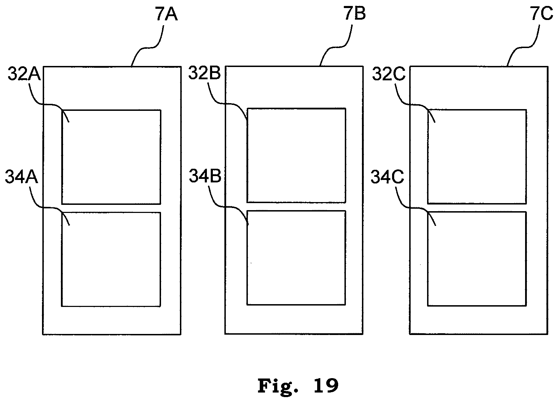

Note that in the embodiment, the case where the cleaning tank 34 and the liquid chemical tank 32 are provided as two tanks (first tank and second tank) is described, but the present invention is not limited to such a case. For example, as illustrated in the schematic plan view of FIG. 19, a different combination of tanks may be used in each of the chemical modules 7A, 7B, and 7C. In an example illustrated in FIG. 19, a first tank 34A of the chemical module 7A is a cleaning tank, and a second tank 32A is a liquid chemical tank. However, both a first tank 34B and a second tank 32B of the chemical module 7B are liquid chemical tanks, and both a first tank 34C and a second tank 32C of the chemical module 7C are one-bath processing tanks. The one-bath processing tank is a tank having both functions of liquid chemical processing and cleaning processing, and has a function of supplying and draining liquid chemical and a function of supplying and draining cleaning liquid.

Liquid chemical used in the first tank 34B and the second tank 32B of the chemical module 7B may be of the same kind or different kinds, and liquid chemical used in the first tank 34C and the second tank 32C of the chemical module 7C may also be of the same kind or different kinds.

As in the layout illustrated in FIG. 19, a combination of the first tank and the second tank is not limited to the cleaning tank 34 and the liquid chemical tank 32, and various combinations can be employed. Any of a liquid chemical tank, a cleaning tank, and a one-bath processing tank may be used for the first tank and the second tank, and an optional combination may be employed.

As described above, in the chemical module 7 of the embodiment, each of the first tank and the second tank is any of a liquid chemical tank for processing the substrate 4 with liquid chemical, a cleaning tank for cleaning the substrate 4, and a one-bath processing tank having a function of processing the substrate 4 with liquid chemical and a function of cleaning the substrate 4. According to such a configuration, the first tank and the second tank can be variously combined.

### Reference Numerals

- 1: substrate processing apparatus
- 2: carrier
- 3: flange portion
- 4: substrate
- 5: loading module
- 6: drying module
- 7: chemical module
- 7a: first chemical module
- 7b: second chemical module
- 7c: third chemical module
- 7d: fourth chemical module
- 8: unloading module
- 9: second conveyance mechanism
- 11: first conveyor
- 12: first actuator
- 13: vertical conveyor
- 14: vertical actuator
- 16: arm
- 18: pedestal
- 20: casing
- 22: placing table
- 24: fan filter unit
- 26: loading unit
- 27: unloading unit
- 29: common exhaust duct
- 31: drying chamber
- 32: liquid chemical tank
- 34: cleaning tank
- 36: side exhaust duct (exhaust duct)
- 36a: side exhaust port (exhaust port)
- 37: side wall
- 37a: gap
- 38: rear wall
- 38a: opening
- 39: rear exhaust duct (exhaust duct)
- 39a: rear exhaust port (exhaust port)
- 40: second conveyance accommodation unit
- 41: second actuator
- 42: rotary actuator
- 43: rotating arm portion
- 44: chuck portion
- 46: link portion
- 48: second conveyor

## Claims

1. A substrate processing module comprising:
a first tank and a second tank that are arranged in a first direction and in which a substrate can be placed;
a first conveyor that moves the substrate in the first direction;
a second conveyor that moves the substrate in a second direction intersecting the first direction; and
a vertical conveyor that is connected to the first conveyor and vertically moves the substrate, wherein
a first actuator of the first conveyor and a second actuator of the second conveyor are respectively arranged in drive spaces separated from a processing space accessible to the first tank and the second tank.

2. The substrate processing module according to claim 1, wherein the first actuator is arranged in a first drive space, and the second actuator is arranged in a second drive space.

3. The substrate processing module according to claim 2, wherein the first drive space is provided on a side and below openings of the first tank and the second tank, and the second drive space is provided on a rear side in the first direction with respect to the processing space.

4. The substrate processing module according to claim 2 or 3, further comprising a rear wall provided behind the processing space, wherein
the second drive space is provided behind the rear wall.

5. The substrate processing module according to claim 4, wherein the rear wall has an exhaust port for exhausting atmosphere of the processing space to the outside.

6. The substrate processing module according to claim 4 or 5, wherein the second conveyor includes an arm extending forward from the second drive space and passing through an opening provided in the rear wall, and a chuck portion connected to the arm and arranged above the first tank.

7. The substrate processing module according to any one of claims 2 to 6, wherein the second drive space can be connected to another module.

8. The substrate processing module according to any one of claims 2 to 7, wherein the second conveyor further comprises a rotary actuator that rotates a chuck portion for holding the substrate, and wherein
the rotary actuator is arranged in the second drive space.

9. The substrate processing module according to any one of claims 1 to 8, wherein a vertical actuator of the vertical conveyor is arranged in the first drive space.

10. The substrate processing module according to any one of claims 1 to 9, wherein each of the first tank and the second tank is any of a liquid chemical tank for processing the substrate with liquid chemical, a cleaning tank for cleaning the substrate, and a one-bath processing tank having a function of processing the substrate with liquid chemical and a function of cleaning the substrate.

11. The substrate processing module according to claim 10, wherein
the first tank is a cleaning tank arranged on a front side in the first direction, and
the second tank is a liquid chemical tank arranged on a rear side in the first direction.

12. The substrate processing module according to any one of claims 1 to 11, wherein the another module is any one of a loading module, an unloading module, a drying module, and a substrate processing module.

13. A substrate processing apparatus comprising:
the substrate processing module according to any one of claims 1 to 12; and
another module connected to the substrate processing module in the second direction.
